(19) Europäisches Patentamt

European Patent Office

Office européen des brevets

(11) **EP 0 303 452 B1**

(12) **EUROPEAN PATENT SPECIFICATION**

(45) Date of publication and mention
of the grant of the patent:
**24.05.2000 Bulletin 2000/21**

(51) Int. Cl.[7]: **G01N 24/08**

(21) Application number: **88307372.8**

(22) Date of filing: **10.08.1988**

(54) **Improvements in or relating to nmr imaging**

Verbesserung von/verbunden mit NMR-Abbildung

Amélioration à/relative à l'imagerie RMN

(84) Designated Contracting States:
**DE FR NL**

(30) Priority: **14.08.1987 GB 8719244**

(43) Date of publication of application:
**15.02.1989 Bulletin 1989/07**

(73) Proprietor:
**BTG INTERNATIONAL LIMITED**
**London EC4M 7SB (GB)**

(72) Inventors:
• **Mansfield, Peter**
**Beeston Nottingham (GB)**
• **Howseman, Alistair**
**Bramcote Nottingham NG9 3JZ (GB)**
• **Ordidge, Roger John**
**West Bridgford Nottingham (GB)**
• **Guilfoyle, David Nigel**
**West Bridgford Nottingham NG2 5JZ (GB)**

(74) Representative:
**Davis, Norman Norbridge**
**BRITISH TECHNOLOGY GROUP LTD**
**10 Fleet Place**
**London EC4M 7SB (GB)**

(56) References cited:
**US-A- 4 567 440**

• **MAGNETIC RESONANCE IN MEDICINE**
• **idem**
• **JOURNAL OF MAGNETIC RESONANCE**
• **MAGNETIC RESONANCE IN MEDICINE vol.1, no. 3., September 1984, pages 370-386, New York, US; P. MANSFIELD: "Spatial Mapping of the chemical Shift in NMR" * pages 380-385: Three-dimensional mapping; figures 1, 5-8 ***
• **JOURNAL OF MAGNETIC RESONANCE vol. 54, 1983, pages 338-343, New York, US; S. Ljunggren: " A Simple Graphical Representation of Fourier-Based Imaging Methods" * figure 2 ***
• **JOURNAL OF MAGNETIC RESONANCE vol.51, 1983, pages 147-152, New York, US; A.A. MAUDSLEY ET AL.: "Spatially Resolved High Resolution Spectroscopy by "Four-Dimensional" NMR" 3 page 147, line1- page 148, line 20 ***
• **MAGNETIC RESONANCE IN MEDICINE vol.1, no. 3., September 1984, pages 370-386, New York, US; P. MANSFIELD: "Spatial Mapping of the chemical Shift in NMR" * pages 380-385: Three-dimensional mapping; figures 1, 5-8 ***
• **JOURNAL OF MAGNETIC RESONANCE vol. 54, 1983, pages 338-343, New York, US; S. Ljunggren: " A Simple Graphical Representation of Fourier-Based Imaging Methods" * figure 2 ***
• **JOURNAL OF MAGNETIC RESONANCE vol.51, 1983, pages 147-152, New York, US; A.A. MAUDSLEY ET AL.: "Spatially Resolved High Resolution Spectroscopy by "Four-Dimensional" NMR" 3 page 147, line1- page 148, line 20 ***

**Description**

IMPROVEMENTS IN OR RELATING TO NMR IMAGING

The present invention relates to NMR (Nuclear Magnetic Resonance) imaging and more particularly to the production of a series of images to study changing phenomena.

Ultra-high speed echo-planar imaging (EPI) (P. Mansfield, J. Physics C10 L55 (1977); P.Mansfield and P.G. Morris, NMR Imaging in Biomedicine Academic Press New York (1982) is now used routinely for clinical studies in both children and adults, (A. Chrispin et al., Ped. Radiol. 16, 289-292 1986 a and b; M. Doyle et al. Lancet 11 682 1986; C. O'Callaghan et al., Arch. Dis. Childhood 63 186-189, 1988 - published after the priority date of this application. In EPI snap-shot images are obtained from a single selectively excited slice in times ranging from 32 msec. to 64 msec. depending on the particular variant used. (B. Chapman et al. Mag. Res. Med. 1987). These relatively short data acquisition times mean that the echo-planar process can be rapidly repeated to produce a real-time movie sequence with immediate visual display of the image.

In terms of imaging time EPI represents a great stride forward, obviating patient motional blurring artefacts which are present in images produced by slower methods. The spatial resolution achievable is also likely to improve by using zonally magnified EPI (P.Mansfield, R.J. Ordidge and R.Coxon, J.Phys.E. 21 275-80 1988) - published after the priority date of this application.

Despite the obvious advantages of EPI, there are particular problems in cardiac imaging. The heart moves in three dimensions not two and EPI being a two dimensional technique, is unable to follow object motions in and out of the imaging plane. This problem of motion along the third axis is exacerbated by respiratory motion. Of course third axis motion may be mitigated by respiratory gating or by a breath hold. However, for a full three dimensional study of the thorax we find it difficult to obtain perfect contiguous matching of adjacent image planes. The problem of exact matching of adjacent planes will be important when looking for the coronary vessels, the ultimate objective of much of the current research in cardiac imaging by NMR.

The above referenced original EPI paper (Mansfield, J. Phys. C 10 L55, 1977) did in fact address the problem of rapid three dimensional imaging from a general standpoint. There, a non-selective pulse is used to uniformly excite the whole of the object volume considered to be contained wholly within and enclosed by the R.F. coil assembly. However, the two dimensional case, given as an example, is the one which has been developed practically and uses single thin slice excitation.

The article by S Ljunggren "A Simple Graphical Representation of Fourier-Based Imaging Methods" - Journal of Magnetic Resonance 54, 338-343 (1983) discloses the use of gradient blips to obtain a rectangular data set in two dimensional imaging.

It is an object of the present invention to provide a method of obtaining (a) volumar images or three dimensional spin density maps from an extended object, only part of which is contained within the R.F. coil assembly, (b) zonally localised volumar images or spin density maps of for example the heart, thereby accommodating the natural movement of the heart in time, and (c) three or four dimensional data arrays or spin parameter maps of which one dimension is chemical shift.

The present invention therefore provides a method of producing a series of nuclear magnetic resonance images as spin parameter maps of a, defined region, as claimed in claim 1.

The spin parameter maps comprise a series of separate slices through the defined region and since each one of the series is taken at a defined time the series can be used to form a plurality of moving sequences at each planar level thereby allowing any movement of a portion of the spin parameter map from one plane to another to be followed in addition to the movement across a plane.

A number of alternative but related methods of volume imaging are now presented. These rely on selective excitation of a thick slice of the object chosen to enclose the volumar region of interest. The first is echovolumar imaging (EVI). (NB. the term EVI is also used as a generic expression for all ultra-high speed volumar imaging). This is basically a four shot method. Experimental results are presented for this method and for a low angle variant in which all four separate experiments merge into a contiguous sequence. The fastest method is blipped EVI (BEVI). This is a true one shot or snap-shot technique Both EVI and BEVI may be combined with zonal magnification or "zooming" to give improved spatial resolution (Mansfield, Ordidge and Coxon, J. Phys. E Vol. 21, 275-80 1988) - published after the priority date of this application. Although there are many obvious workable multi-shot variants, we shall concentrate here on a true one-shot technique, ZEVI-1. All variants can be combined with low angle pulses for real-time volumar imaging or 3D spin parameter mapping.

Embodiments of the present invention will now be described, by way of example with reference to the accompanying drawings in which :-

Figure 1 shows pulse time diagrams for BEVI;

Figure 2 shows k-space trajectory projections for EVI;

(a) Projection as seen along the $k_z$ axis.
(b) Projection as seen along the $k_y$ axis.

Dotted lines represent alternative trajectories.
Figure 3 shows a sketch of part of a three dimensional k-space trajectory for BEVI;
Figure 4 shows a sketch showing zonal volume definition (shaded) for ZEVI;
Figure 5 shows a timing diagram and pulse sequence for ZEVI-1;
Figure 6 shows a volume image of a water filled conical flask obtained by EVI;

(a) Image spectrum and image projection.
(b) Separate images of the 16 planes in (a).

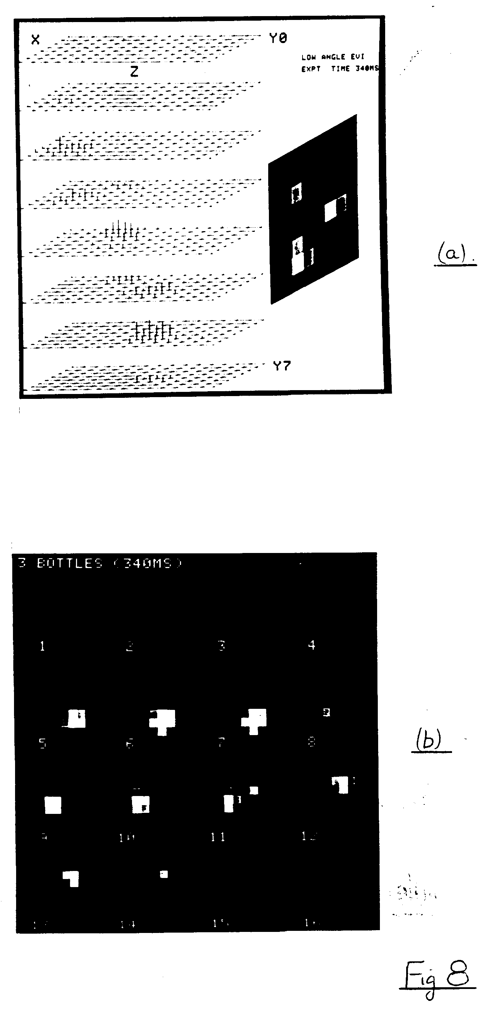

N.B. The flask axis is aligned along the z-axis with the neck to the right in (a) tapering to the tip in image 16 of (b). The selective slice thickness was 90 mm. The pixel resolution in the x,y-plane is 24 mm which gives rise to a coarse chunky appearance to the images here and in Figures 7 and 8.
Figure 7 shows a volume image obtained by EVI of a water filled hemispherical phantom with a solid plug (dark central spot).

(a) Image spectrum and image projection.
(b) Separate images of the 16 planes in (a).

The cylindrical axis lies along the z direction with the flat face to the right in (a) corresponding to images 14 and 15 in (b). The selective slice thickness was 56 mm; and
Figure 8 shows a rapid echo-volumar image of three water filled bottles using low angle excitation pulses. The imaging time was 340 msec and includes three delays each of 66 msec.

(a) Image spectrum and image projection.
(b) Separate images of the 16 planes in (a), and.

Theory of EVI (Echo-Volumar Imaging)

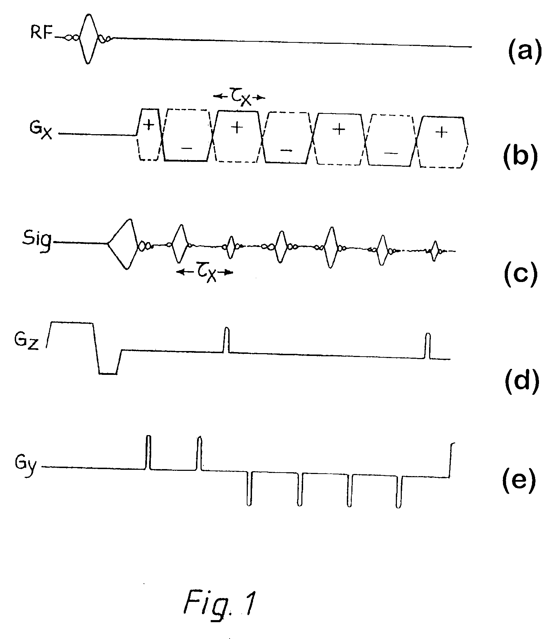

Figure 1 shows the pulse timing diagrams for Blipped (BEVI) EVI (a-e) Figure 1(d) shows the initial thick slice selection procedure in $G_z$ together with the selective RF pulse (a), the z-axis gradient (d) and the periodically modulated gradients $G_x$ and $G_y$ (b) and (e). (NB the gradient is ideally of rectangular waveform, however, in practice a trapezoidal waveform may be used together with non-linear sampling of the signal. Other waveforms may be used including cosinusoidal modulation provided non-linear sampling is also used. Also shown in Figure 1 is the nuclear signal (c) The waveforms for $G_z$ (d) and $G_y$, (e) show the z-axis broadening and y-axis encoding gradients applied in the form of short duration blips.
The free induction decay signal S(t) in the rotating reference frame at time t following slice selection, is given by

$$S(t) = S(\underline{k}) = r.p. \int \rho(\underline{r}) \exp\{i\underline{k}.\underline{r}\} d\underline{r} \qquad (1)$$

where $\rho(\underline{r})$ is the spin density within the slice at position $\underline{r}$, and $\underline{k}$ is the reciprocal space wave vector (10, 11) (P. Mansfield & P.K. Grannell J.Phys C6 L422 (1973) and S.Ljunggen J.Mag Res Med 1 370-376 (1984)) given by

$$\underline{k} = \int_0^t \gamma[\underline{i}G_x(t') + \underline{j}G_y(t') + \underline{k}G_z(t')]dt' \qquad (2)$$

in which $\gamma$ is the magneto-gyric ratio and $G_x(t')$, $G_y(t')$ and $G_z(t')$ are time dependent linear magnetic field gradients.

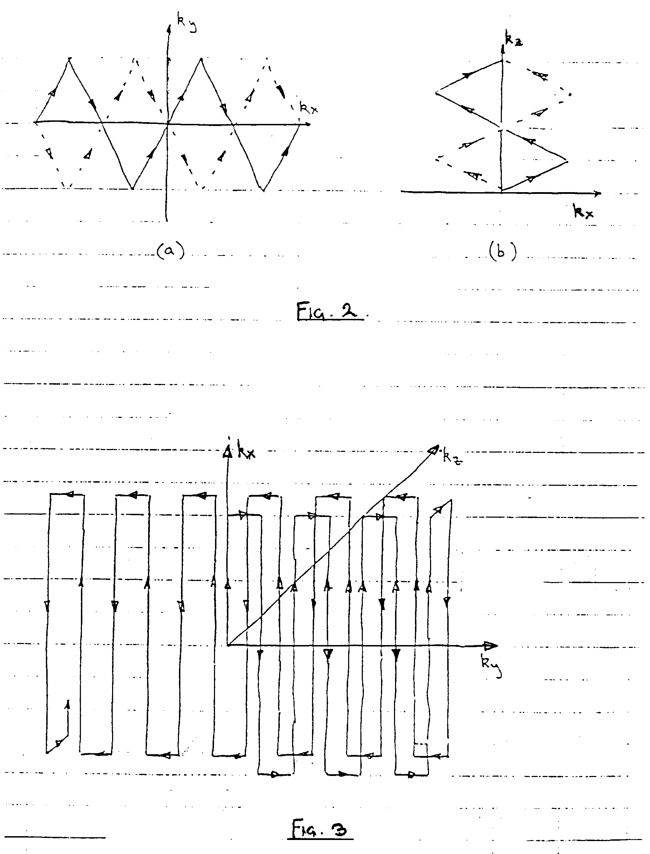

Figure 2a shows the z-axis projection of the k-space pathway scanned in EVI. Figure 2b shows the pathway in the x-z plane. In both Figures the dotted lines are alternative pathways which correspond to a change of the starting phase of the appropriate gradient (see Figure 1). In performing the Fourier transform (FT) of the k-space map it is necessary that the arrows point in the same direction on each projection. This can be achieved by performing four experiments in which all permutations of the starting phases of the x- and y- gradients are used. This gives four different possibilities for the nuclear signal S(t) which we denote as $S^{++}$, $S^{+-}$, $S^{-+}$ and $S^{--}$. All four signals are then edited and spliced to give four edited signals $E^{++}$, $E^{+-}$, $E^{-+}$ and $E^{--}$ which effectively evolve in either a wholly +ve or a -ve y-gradient and in either a wholly +ve or a -ve x-gradient. In this arrangement the z-gradient may be either +ve or -ve for all permutations of the x- and y-gradients. In a straightforward extension of these principles, four dimensional scans may be produced by allowing the z-gradient also to be modulated. We would then have eight permutations of the starting phases of the x-, y- and z-gradients. The fourth dimension so created could be used to map chemical shifts and/or hyperfine interactions.

The echo-planar shift mapping (EPSM) technique, described elsewhere (P. Mansfield, Mag. Res. Med. 1, 370-386 (1984), D.N. Guilfoyle and P. Mansfield, Mag. Res. Med. 2, 479-489 (1985)), is a related three dimensional experiment (x, y and chemical shift) which also uses two modulated gradients in addition to the slice selection gradient.

The above described three dimensional scanning procedure is a four shot process which may be combined into either two two-shot pulse sequences or a single sequence by use of suitable low angle selective RF pulses. In either case the nutation angles of successive pulses must satisfy the recursion relationship P. Mansfield Mag.Res.Med. 1 370-386 (1984).

$$\tan\alpha_n = \sin\alpha_{n+1} \qquad (3)$$

where n is integer and where the last pulse always has a nutation angle of 90°. For pairs of pulses the angles are 45° and 90°. For a single experiment using four low angle pulses the angles are 30°, 35.26°, 45° and 90°. The editing and splicing process results in four separate three dimensional images which may be coadded into a single image with a factor 2 improvement in signal-noise ratio.

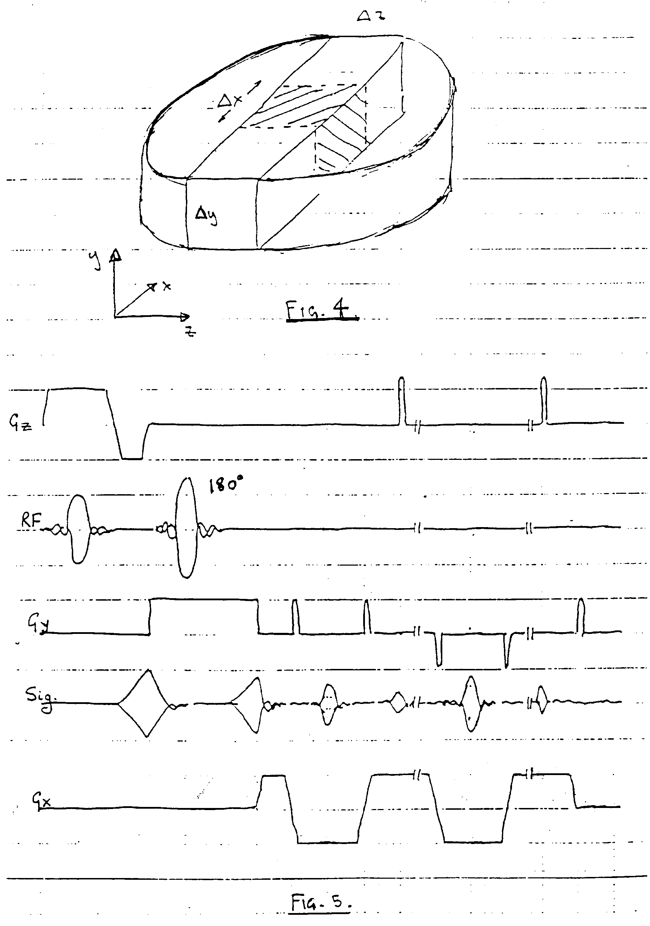

The blipped gradient version described in Figure 1 (BEVI) is a true one-shot imaging process in which the signal is recorded after one selective pulse which may have an arbitrary nutation angle $\alpha°$. In this case it is possible to arrange traversal of k-space in one pass as sketched in Figure 3. To achieve this z- and y-gradient blips are applied together with trapezoidal or other general modulation of the x-gradient such that the y-blips correspond to the zero crossings in $G_x$. The z-blips as sketched are applied less frequently at the effective zero crossings where the phase of the $G_y$ gradient changes sign. The nuclear signal comprises a series of fast spin echoes in $G_x$ modulated by slower echoes in $G_y$. The whole echo train decays away due to the z-gradient broadening blips. Again, however, the arrows for each z-plane should be pointing in the same direction. This is achieved simply by reversing appropriate echoes corresponding to the arrowed portions of k-space in Figure 3. Just as in EVI there are eight possible experiments corresponding to the various permutations of the signs of the gradients each one of which is capable of producing a full image. Only two eases are illustrated in Figure 1.

For suitably spliced echo volumar images and also for blipped EVI when there is insignificant signal decay over the duration of an individual echo, it can be shown that for discrete signal sampling, (linear or non-linear depending on the whether square-wave gradient modulation or some other general waveform modulation is used), the edited EVI time signals are equivalent to the discrete functions.

$$E^{+++}(t) = \Sigma \ \Sigma \ \Delta x \Delta y \Delta z \rho_{lmn} \cos[l\Delta\omega_x + m\Delta\omega_y + n\Delta\omega_z]t \qquad (4)$$

where l, m and n and integers and $\rho_{lmn}$ is the density of the l,m,nth voxel with volume $\Delta x \ \Delta y \ \Delta z$. The superscripts $+++$ refer to the various combinations of starting phase and/or amplitude sign of the three gradients.

The discrete Fourier transform of equation (4) over a sampling period T yields a stick spectrum with a discrete point spacing of

$$\Delta\omega = \Delta\omega_x = 2\pi/T = \gamma\Delta z G_x \qquad (5)$$

a y-stick spacing of

$$\Delta\omega_y = 2\pi/\tau_y = \gamma\Delta y G_y \qquad (6)$$

and an x-stick spacing of

$$\Delta\omega_x = 2\pi/\tau_x = \gamma\Delta x G_x. \tag{7}$$

For non-overlap of spectral components and for fixed overall receiver bandwidth $\Delta\Omega$, we must satisfy the conditions

$$\Delta\Omega = L\Delta\omega_x = LM\Delta\omega_y = LMN\Delta\omega_z = P\Delta\omega_p \tag{8}$$

where L,M and N are the largest values of l,m and n which span the object field and where the total number of points describing the image is

$$P + LMN \tag{9}$$

From Figure 1 and from equations (5)-(8) we may also write

$$\tau = P\tau = N\tau_y = NM\tau_x \tag{10}$$

for a complex FT where $\tau$ is the sampling period and the x- and y-gradient echoes are modulo $\tau_x$ and $\tau_y$ respectively P Mansfield, P.K. Grannel J. Phys. C $\underline{6}$ L422 (1973). Furthermore, for equal resolution the gradient strengths are given by

$$G_y = NG_z \tag{11}$$

and

$$G_x = MG_y = NMG_z \tag{12}$$

An alternative to BEVI which places lower demands on the gradient coil switching capability is the single shot EVI (SEVI) method. This creates an image by performing one EVI experiment and processing the data by re-ordering planes and reversing lines within planes as in BEVI. The distribution of data points in reciprocal space is not uniform in this case, but a software correction may be used to compensate for this.

Zoomed EVI (ZEVI)

There are several possibilities for producing zonally magnified (zoomed) echo-volumar images which combine the present work with that of zoomed echo-planar imaging, (ZEPI), (Mansfield, Ordidge and Coxon J.Phys.E Vol 21 275-80 1988) - published after the priority date of this application. Most of these possibilities, however, are multi-shot methods. The greatest potential of ZEVI is for localised volume studies in the heart. For this reason we concentrate on a one shot zoom technique ZEVI-1.

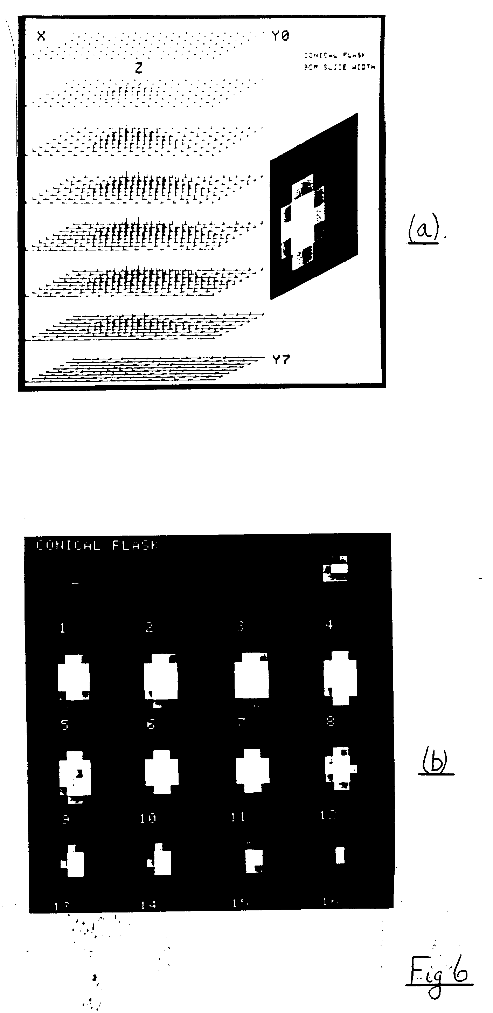

The volume of interest is defined along two axes, z and y, by use of selective pulses and appropriate gradients, Figure 4. The extent along the x- axis is defined by the receiver bandwidth $\Delta\Omega$. Equation (8) together with Equations (5 - 7) determine the resolution and volume array size.

The detailed pulse timing diagrams for ZEVI-1 are shown in Figure 5. An initial thick slice is excited in $G_z$ with a selective RF pulse having a nutation angle $\alpha°$. With $G_z$ off and $G_y$ switched on a selective 180° pulse is applied which refocuses the spins in the desired column. At this point a modulated x-gradient is applied together with z- and y-gradient blips.

The single free induction decay sequence must be appropriately reordered. This is done by reversing the time data on alternate fast echoes and on alternate slow echoes. When this is done a single Fourier transform may be used to produce the image array. For the data reordering to work well, we require the snapshot imaging time to be less than the spin-spin relaxation time $T_2$.

Design Example

Let the selected volume be cubic with a side of 100 mm. Let L = M = 20  and N = 10 making an array of 20 x 20 x 10 voxels. This comprises 10 planes each of thickness 10 mm with an in-plane resolution of 5 mm. Take the imaging time T = 64 ms giving a frequency per point, Equation (5), of 16 Hz. In EVI the required x-gradient is 1.52 G/cm. The y- and z-gradients are 75 mG/cm and 3.8 mG/cm respectively. In this example $\Delta\Omega$ = 64 kHz. When $G_y$ and $G_z$ are applied in the form of short blips of duration $t_B$ as in BEVI, their amplitudes become approximately, $G_y \simeq 76\ (\tau_y/t_B)$mG/cm

and $G_x \approx 1.52(\tau_x/t_B)$G/cm.

Experimental EVI Results

Some preliminary experimental results have been obtained using the elementary EVI 4 shot sequence as a vehicle to test the principles. In these experiments the object field was 192 x 192 mm$^2$. The total number of points describing the image data array, P = 1024 with L = M = 8 and N = 16. That is to say the three dimensional image consists of 16 planes each comprising an 8 x 8 image array. The in-plane pixel resolution is therefore 24 mm giving rather coarse images in the x, y-plane. The resolution along the z-axis depends on the thickness of the initially excited selective slice. This varies in the examples given.

The timing parameters used were: T = 32 ms, $T_y$ = 2.0 ms and $T_x$ = 0.25 ms. The waveforms were approximately rectangular (trapezoidal) so that linear signal sampling was used. The x-gradient modulation frequency was 4.0 kHz. At this relatively high frequency it is probably better to use sinusoidal modulation together with non-linear sampling, especially with a larger object field. However, this strategy is more easily accomplished in BEVI.

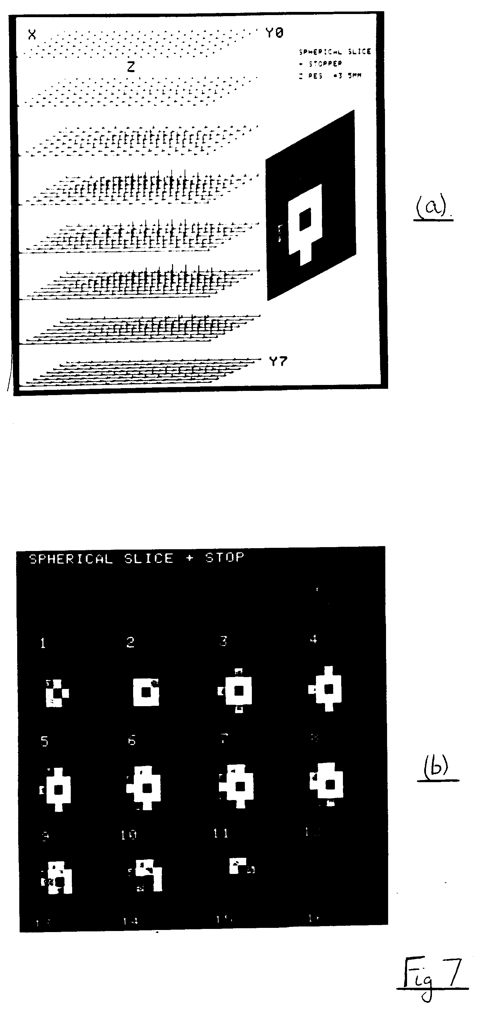

Figure 6a shows the three dimensional spectrum corresponding to a water filled conical flask with its cylindrical axis aligned along the z direction. Each grid layer corresponds to one of 8 y-planes labelled (Y0-Y7). The x- and z-axes have 8 and 16 divisions respectively. Also inset on this Figure is the image projection along the z-axis. Figure 6b shows the individual images in every z-plane. The initial slice thickness was 90 mm. The complete volume image was obtained in 4 s.

Another example of an EVI spectrum is shown in Figure 7a. The object here is a hemispherical water phantom containing a cylindrical plug of solid material. The cylindrical axis of the hemisphere is along the z-direction. The flat surface of the object lies approximately in the z-plane at level 15. The initial slice thickness was 56 mm. This volume image took 4 s to produce.

Figure 8a and 8b are echo-volumar images of a water filled phantom consisting of three short bottles resolved in the x, y plane and displaced along the z-axis. The results were obtained in four shots using a low angle selective pulse. The total imaging time was 340 ms.

Conclusion

By suitable introduction of spatial encoding along a third axis it is possible to perform rapid volume imaging. One form of this, EVI, is a four shot technique requiring four separate experiments before an image can be unambiguously extricated from the data. The time to produce an image by this means depends on the delay between shots. By using low angle pulses we have been able to take all four shots in 340 ms, though it is possible to take even shorter times.

An alternative volume imaging method, BEVI, uses gradient blips to spatially encode along the y- and z-axes. This is a true snapshot volumar imaging technique which takes between 32 - 64 ms to perform. The rather large gradients required, combined with a very wide receiver bandwidth, mean that neither EVI nor BEVI are likely to find application in high resolution medical imaging, however a further alternative which overcomes the bandwidth problem but still requires substantial gradients is ZEVI. In this method a small volume is selectively excited within the subject and a three dimensional image formed. The third axis of the required volume is defined by the receiver bandwidth. The ZEVI-1 technique is a snapshot process and operates at fixed receiver bandwidth. Depending on gradient strengths available, the method can be used to zoom into smaller and smaller volumes with fixed array size. Using a combination of selective pulses and extra sampling and bandwidth, the selected volume can be steered throughout the larger volume of the subject so as to interrogate the spin system as required. ZEVI-1 could therefore find application in cardiac and other types of medical imaging.

As a variation to the proposed volumar imaging technique, a rapid multishot sequence can be performed by applying a modulated y gradient and a blipped x gradient in each sequence, with phase encoding using an incremented (or decremented) z gradient in successive experiments to form the third image direction. The RF excitation pulse can either be non-selective or select a broad slice for 3D imaging of a thick slab of material. The experiments may be applied in rapid succession if the RF pulse causes a low nutation angle 10°-45° typically), and 3D imaging may thus be achieved in an experiment lasting a few seconds.

The x gradient blips may be preceded by a large negative x gradient pulse to cause an effective spin echo in x gradient evolution midway through the experiment. The time data may then be treated with a magnitude Fourier transform to avoid distortion of the image through phase non-uniformity.

**Claims**

1.    A method of producing a series of nuclear magnetic resonance images from an object placed in an MRI apparatus comprising the steps of:

    a) maintaining a static magnetic field;
    b) providing a nutating RF pulse;
    c) providing first, second and third mutually orthogonal magnetic field gradients ($G_z,G_x,G_y$) which are modulated in a manner to obtain an echo planar image;
    d) detecting and processing the nuclear magnetic resonance signal so produced; and
    e) displaying the data contained within the processed signals as spin parameter maps;
    characterised in that
    in step b) the nutating RF pulse is a selective pulse and is applied in the presence of said first one orthogonal magnetic field gradient ($G_z$) which is chosen to have a magnitude to select a thick slice of spins consisting of a plurality of parallel planes orthogonal to the direction of said one magnetic field gradient and thus to define a region of the object to be imaged, in which subsequent to the slice selection the said first and third orthogonal magnetic field gradients ($G_z,G_y$) are applied as a series of blips.

2.  The method as claimed in claim 1 in which a said magnetic field gradient ($G_x$) is time modulated in a trapezoidal, sinusoidal or cosinusoidal manner.

3.  The method as claimed in claim 1 in which following selection of the thick slice of spins a selective 180° RF pulse is applied in the presence of the third magnetic field gradient ($G_y$) to refocus a column of spins in the thick slice.

**Patentansprüche**

1.  Verfahren zum Erzeugen einer Reihe von Bildern mittels magnetischer Kernresonanz von einem in einem MRI-Gerät angeordneten Objekt, mit den Schritten:

    a) Aufrechterhalten eines statischen Magnetfeldes;
    b) Vorsehen eines schwankenden HF-Pulses;
    c) Vorsehen erster, zweiter und dritter wechselseitig orthogonaler Magnetfeldgradienten ($G_z$, $G_x$, $G_y$), die in einer Art und Weise moduliert werden, um ein Echoplanar-Bild zu erhalten;
    d) Feststellen und Verarbeiten des so erzeugten Signals der magnetischen Kernresonanz; und
    e) Anzeigen der innerhalb der verarbeiteten Signale enthaltenen Daten als Spinparameter-Abbildungen;
    dadurch gekennzeichnet, daß
    in Schritt b) der schwankende HF-Puls ein selektiver Puls ist und bei Vorhandensein des ersten orthogonalen Magnetfeldgradienten ($G_z$) angewendet wird, welcher so gewählt wird, daß er eine Größe hat, um eine dicke Scheibe von Spins auszuwählen, die aus mehreren, parallelen, zur Richtung des einen Magnetfeldgradienten orthogonalen Ebenen besteht, und um so einen abzubildenden Bereich des Objektes zu definieren, in welchem nach der Scheibenauswahl der erste und dritte orthogonale Magnetfeldgradient ($G_z$, $G_y$) als eine Reihe von Echopulsen angewendet werden.

2.  Verfahren nach Anspruch 1, in welchem der Magnetfeldgradient ($G_x$) in einer trapezförmigen, sinusförmigen oder cosinusförmigen Art und Weise zeitlich moduliert wird.

3.  Verfahren nach Anspruch 1, in welchem nach einer Auswahl der dicken Scheibe von Spins bei Vorhandensein des dritten Magnetfeldgradienten ($G_y$) ein selektiver 180°-HF-Puls angewendet wird, um eine Säule von Spins in der dicken Scheibe nachzufokussieren.

**Revendications**

1.  Procédé pour produire une série d'images de (résonance magnétique nucléaire) à partir d'un objet placé dans un dispositif d'IRM comportant les étapes consistant à :

    a) maintenir un champ magnétique statique ;
    b) fournir une impulsion radio-fréquence en nutation ;
    c) fournir des premier, deuxième et troisième gradients de champ magnétique mutuellement orthogonaux ($G_z$, $G_x$, $G_y$) qui sont modulés de manière à obtenir une image d'écho plane ;
    d) détecter et traiter le signal de résonance magnétique nucléaire ainsi produit ; et
    e) afficher les données contenues dans les signaux traités sous la forme de cartes de paramètres de spin ;

caractérisé en ce que

à l'étape b), l'impulsion radio-fréquence en nutation est une impulsion sélective et est appliquée en la présence dudit premier gradient de champ magnétique orthogonal ($G_z$) qui est choisi de manière à avoir une amplitude permettant de sélectionner une tranche épaisse de spins constituée d'une pluralité de plans parallèles perpendiculaires à la direction dudit premier gradient de champ magnétique et, par conséquent, à définir une région de l'objet à visualiser, étape au cours de laquelle, après la sélection de la tranche, lesdits premier et troisième gradients de champ magnétique orthogonaux ($G_z$, $G_y$) sont appliqués sous la forme d'une série de (blips).

2. Procédé selon la revendication 1, dans lequel un gradient de champ magnétique ($G_x$) est modulé dans le temps d'une manière trapézoïdale, sinusoïdale ou cosinusoïdale.

3. Procédé selon la revendication 1, dans lequel, après la sélection de la tranche épaisse de spins, une impulsion radio-fréquence à 180° sélective est appliquée en la présence du troisième gradient de champ magnétique ($G_y$) de manière à refocaliser une colonne de spins dans la tranche épaisse.

Fig. 1

(a)
(b)

Fig. 2.

Fig. 3

Fig. 4.

Fig. 5.

(a).

(b)

Fig 6

(a)

(b)

Fig 7

13

(a).

(b)

Fig 8